Europäisches Patentamt

**European Patent Office**

Office européen des brevets

(19)

(11) **EP 0 707 231 A2**

(12) **EUROPEAN PATENT APPLICATION**

(43) Date of publication:
17.04.1996 Bulletin 1996/16

(51) Int. Cl.[6]: **G02F 1/1335**, G03F 1/00,
G03C 7/12

(21) Application number: 95115946.6

(22) Date of filing: 10.10.1995

(84) Designated Contracting States:
CH DE FR GB LI NL SE

(30) Priority: 13.10.1994 JP 275620/94

(71) Applicant: SHINTO PAINT CO., LTD.
Amagasaki (JP)

(72) Inventors:
• Watanabe, Tsutomu
Yamada, Itami-shi (JP)

• Yasukawa, Jun-ichi
Chigasaki-shi (JP)
• Ota, Toshiaki
Narashino-shi (JP)
• Tokuda, Tuyoshi
Yachiyo-shi (JP)

(74) Representative: VOSSIUS & PARTNER
Siebertstrasse 4
D-81675 München (DE)

(54) **Method for repairing a defective color filter**

(57) A color filter having a plurality of color layers on the surface of a transparent substrate, at least one of the color layers having a defect of layer unflatness, which is produced due to unevenness caused by contamination with foreign matters is repaired by a simple, industrially advantageous method.

The method includes the steps of

(1) eliminating a defective part of the color layers to produce a blank there,
(2) filling the blank with a negative type photosensitive composition containing a colorant, and
(3) exposing the photosensitive composition to light emitted from the side opposite to the color layer-carrying surface of the substrate, followed by development to eliminate the photosensitive composition unexposed to light.

The color filter repaired is used to fablicate multicolor display devices which are by no means inferior in display qualities to those fablicated using a color filter having no defect originally.

EP 0 707 231 A2

## Description

The present invention relates to a method for repairing a defective color filter, a color filter repaired and a multi-color display device provided with the same.

More specifically, the present invention relates to a method for repairing a color filter having a plurality of color layers, at least one of the color layers having a defect of layer unflatness, which is produced due to unevenness caused by contamination of the color layer with foreign matters, and also relates to a color filter repaired and a multi-colored display device provided with the same.

A color filter suitable for use in multi-color display devices such as color liquid crystal displays (LCD) has been manufactured by a dyeing method, a pigment dispersion method, an electrodeposition method, a printing method or the like, according to which the color layers including multi-colored pixels such as red-, green- and blue-colored pixels and black matrices interlaced between the pixels are formed on the surface of glass or other transparent substrates.

In any method mentioned above, it is difficult to avoid contamination of the color layers with dust, waftings in the air and the like during the color layer formation process. Moreover, pigments used as a colorant for the formation of color layers may aggregate under a certain condition and the resulting aggregates contaminate color layers to produce unevenness thereof.

An effort to avoid contamination of the color layers with foreign matters such as dust, waftings in the air, pigment aggregates and the like has been continued, but an industrially economical method to solve the problem has not yet been found.

However, disposal of such defective color filter is not economical from an industrial point of view. Therefore, it has been strongly desired to find an effective method for correcting the defect of layer unflatness caused by contamination of the color layers with foreign matters.

JP-A-4-369604 proposes a method for repairing such defective color filter, which comprises forming a protective film of a material having both flexibility and stripping property on colored pixels including a defective pixel, applying a laser beam to eliminate the defective part of the pixel together with the protective film formed on the defective part, filling the resulting blank with a thermosetting or photo-curable light-screening material of the same color as that of the defective pixel, successively stripping the remaining protective film mechanically, while leaving the light-screening material filled in the blank, and thereafter applying heat or UV ray to cure the light-screening material.

The method is too complex, because it necessitates at least steps of formation and stripping of the specific protective film. Therefore, further improvement has been desired.

Thus, an object of the present invention is to provide an industrially advantageous method for repairing a color filter having a plurality of color layers, at least one of them having the said defect of layer unflatness.

Another object of the present invention is to provide a color filter having a plurality of color layers, at least one of them having the said defect which has been corrected, so that the color filter repaired can be used to fablicate multi-color display devices which are by no means inferior in the display qualities to those fablicated using a color filter having no defect originally.

Further object of the present invention is to provide a multi-color display device provided with the color filter repaired.

These and other objects can be attained by providing a method for repairing a color filter having a plurality of color layers on the surface of a transparent substrate, at least one of the color layers having a defect of layer unflatness, which is produced due to unevenness caused by contamination of the color layers with foreign matters, which comprises the steps of

(1) eliminating a defective part of the color layers to produce a blank there,
(2) filling the blank with a negative type photosensitive composition containing a colorant, and
(3) exposing the photosensitive composition to light emitted from the side opposite to the color layer-carrying surface of the substrate, followed by development to eliminate the photosensitive composition unexposed to light.

The objects can be attained also by providing a color filter having a plurality of color layers, at least one of them having the said defect which has been corrected by the said method, and a multi-color display device provided with the color filter repaired.

The present invention is explained in detail as follows.

In the present invention, the formation of color layers on a transparent substrate to obtain a color filter can be carried out by a dyeing method, a pigment dispersion method, an electrodeposition method, a printing method or others, which are all well known in this art.

Of these color filter manufacturing methods, particularly preferred is the electrodeposition method.

According to the electrodeposition method, it is known that the color layers are formed with high precision on electroconductive layers formed in advance on the surface of a transparent substrate.

It is also known that the method is simple in process, high in yield and low in manufacturing cost.

The method can be carried out, in general, by putting both a substrate having an electroconductive layer on the surface thereof as one electrode and another electrode as a counter electrode into an electrodeposition bath, applying a voltage thereto to form color layers on the electroconductive layer and then heating the color layers formed.

More concretely, the method is mentioned in, for example, JP-A-61-272720, U.S. Patent No. 4,812,387 or JP-A-62-247331, and JP-A-6-130379.

The method mentioned in JP-A-6-130379 comprises forming a positive photoresist layer on a transparent substrate having an electroconductive layer thereon, eliminating the photoresist layer discretely to bare the surface of the electroconductive layer in a window like form, subjecting the substrate to electrodeposition in order to obtain discrete colored pixels, eliminating the remaining window-frame like photoresist layer and then forming black matrices in the resulting window-frame like blank according to a so-called back-face exposure method, wherein a photo-curable material containing a black pigment is coated on the whole surface of the substrate including the discrete colored pixels, and the photo-curable material coated is exposed to light emitted from the side opposite to the colored pixels-carrying surface of the substrate, followed by development to eliminate the unexposed portion of the photo-curable material.

In the present invention, the color layers can be formed also by a modification of this method, wherein the positive photoresist layer is eliminated first in a window-frame like form, followed by the formation of black matrices therein, and then the remaining window like form photoresist layer is eliminated, followed by the formation of colored pixels therein.

The color layers formed by the afore-mentioned methods are those functioning as a photo-mask in the light-exposure step of the present invention.

In step (1) of the present invention, a defective part of the color layers is eliminated. The phrase "a defective part of the color layers" is to mean one or more parts of color layers at which unevenness caused by contamination of the color layers with foreign matters is found. The unevenness is easily caused particularly during the afore-mentioned color layer formation process.

Although the elimination can be carried out in any known manner, it can be industrially advantageously carried out by applying a laser beam to the defective part. A wavelength of the laser beam is preferably about 1 $\mu$m or less, more preferably about 0.6 $\mu$m or less.

The elimination is conducted until the color layer at the defective part is completely removed to produce a blank there.

Favorably, the defective part only is eliminated, but it is allowable to extend the elimination somewhat to circumference of the defective part.

In step (2), the resulting blank produced by the elimination of the defective part in step (1) is filled using as a correcting material a negative type photosensitive composition containing a colorant.

The negative type photosensitive composition may be any one so far as a light-exposed portion of the composition can be easily cured, while a light-unexposed portion thereof can be dissolved and eliminated by development.

The composition can be prepared using at least one photosensitive material such as acrylic, urethane or epoxy resin, synthetic rubber, polyvinyl alcohol, rubber, gelatin and the like, photo-polymerization initiators such as benzophenone, anthraquinone and the like, reactive diluents and photo-sensitizers. Alternatively, commercially available negative photoresist compositions such as OMR-83 (manufactured by Tokyo Ohka Co. Ltd.), commercially available photo-curable paints and inks can be also used.

The colorant is not particularly limited. It includes preferably a pigment. Preferred examples of the pigment are red pigments such as red iron oxide, azo, quinacridone and perylene pigments, green pigments such as phthalocyanine green pigment, blue pigments such as phthalocyanine blue pigment, black pigments such as carbon black, aniline black and black iron oxide. These pigments can be used each alone or a mixture of two or more.

It is preferred to use the colorant having a color similar to that of the defective color layers. If so, there is no limitation as to the size of the defective color layer to be corrected.

In the present invention, it has been found that a colorant of a black color to be used for the correcting material has no bad effect upon display qualities of the multi-color display devices regardless of a color of the defective color layers, when the diameter of a blank produced by the elimination of the defective part is not more than about 250 $\mu$m, preferably not more than 200 $\mu$m, in case of an about 100 $\mu$m pitch color filter having, for example, about 80 $\mu$m of pixel width and about 20 $\mu$m of black matrix width, provided that the diameter of the blank is calculated by the following equation,

$$[(\text{long side diameter of the blank}) + (\text{short side diameter of the blank})]/2$$

Accordingly, when the color layers are formed to obtain an about 100 $\mu$m pitch color filter by the electrodeposition method as mentioned in, for example, the aforementioned U.S. Patent No. 4,812,397 and JP-A-6-130379, wherein black matrices are formed using a black pigment-containing photo-curable material according to the back-face exposure method, the black pigment-containing photo-curable material used therefor can be used also as the correcting material as it is.

The filling of the blank can be performed by coating an area of the color layers including the blank with the negative type photosensitive composition. The coating can be carried out in any known manner such as coating with a writing brush. In this coating process, it causes no trouble to coat the uneliminated color layers besides the blank, because the color layers function as a photo-mask in the following light-exposure step, so that the negative type photosensitive composition coated on the uneliminated color layers is left unexposed, and removed by the following development.

A thickness of the coating layer to be formed in the blank can readily be controlled by selecting the content of the negative type photosensitive composition and/or a light exposure in the following step.

In step (3), the negative type photosensitive composition coated is exposed to light through the uneliminated and remaining color layers, which function as a photo-mask, followed by development in order to eliminate the negative type photosensitive composition unexposed to light.

In carrying out the exposure to light, lights having various wavelength can be applied depending on the kind of the negative type photosensitive composition. In general, however, lights of UV region are preferred. A preferable light source usable therefor includes a super-high pressure mercury lump, a metal halide lump and the like.

Although the conditions of the exposure to light vary depending on the light source and the kind of the negative type photosensitive composition, a preferable light exposure ranges from 100 to 4000 mJ/cm$^2$.

The development can be carried out in order to eliminate the negative type photosensitive composition unexposed to light using a suitable developing agent. The agent includes, for example, aqueous solution of sodium hydroxide, sodium carbonate, quarternary ammonium salts or organic amines, and organic solvents such as esters, ketones, alcohols, chlorinated hydrocarbones and the like.

The development can be performed by dipping or showering the substrate into or with the developing agent for about 10 seconds to 5 minutes. Desirably, the substrate is, thereafter, washed thoroughly with water or organic solvents.

According to the method of the present invention, a color filter having a plurality of color layers, at least one of the color layers having a defect of layer unflatness, which is produced due to unevenness caused by contamination of the color layer with foreign matters particularly in a process of forming the color layers, can be repaired in a simple and industrially advantageous manner. The color filter repaired can be used to fablicate multi-color display devices such as color liquid crystal displays (LCD) in a conventional manner. The devices fablicated are by no means inferior in the display qualities to those fablicated using a color filter having no defects originally.

The present invention is illustrated in more detail with reference to the following Example, which is only a preferred embodiment of the present invention.

Example

In a manner similar to that of Example 1 of the afore-mentioned U.S. Patent No. 4,812,387, was obtained a 100 μm pitch color filter having, in a stripe form, red, green and blue-colored pixels of each 80 μm width, between which black colored layers (black materials) of 20 μm width were formed.

A laser beam of 0.53 μm wavelength was irradiated to three parts of the color layers to make three blanks, where the surfaces of the glass substrate and/or ITO circuit appeared in about 200, 150 and 100 μm diameters, respectively, the diameters being calculated by the afore-mentioned equation.

The same aniline black-containing, negative type photosensitive composition as used above for the formation of black matrices was coated on areas including the three blanks at a length of 1 mm diameter, respectively, using a writing brush, whereby the three blanks were thoroughly filled therewith.

Thereafter, Example 1 of the said Patent was repeated for the exposure to light and the successive development, thereby obtaining the color filter repaired.

The color LCD fablicated in a conventional manner using the resulting color filter showed display qualities similar to that fablicated using a color filter having no defect originally.

**Claims**

1. A method for repairing a color filter having a plurality of color layers on the surface of a transparent substrate, at least one of the color layers having a defect of layer unflatness, which is produced due to unevenness caused by contamination of the color layer with foreign matters,
   which comprises the steps of

   (1) eliminating a defective part of the color layers to produce a blank there,
   (2) filling the blank with a negative type photosensitive composition containing a colorant, and
   (3) exposing the photosensitive composition to light emitted from the side opposite to the color layer-carrying surface of the substrate, followed by development to eliminate the photosensitive composition unexposed to light.

2. The method according to Claim 1, wherein the color layers are red, green, blue and black color layers formed on the surface of a glass substrate.

3. The method according to Claim 2, wherein at least the red, green and blue color layers are formed by an electrodeposition method.

4. The method according to any of claims 1 to 3, wherein the elimination of the defective part is carried out using a laser beam.

5. The method according to Claim 4, wherein a wavelength of the laser beam is 1 µm or less.

6. The method according to any of claims 1 to 5, wherein the blank produced in step (1) has a diameter of not more than about 250 µm, and is filled in step (2) with a negative type photosensitive composition containing a black pigment.

7. A color filter having a plurality of color layers, at least one of the color layers having a defect of layer unflatness which has been corrected by the method of Claim 1.

8. A color filter having a plurality of color layers, at least one of the color layers having a blank of a diameter of not more than about 250 µm, which has been filled with a negative type photosensitive composition containing a black pigment.

9. A multi-color display device provided with the color filter of Claim 7.

10. A multi-color display device provided with the color filter of Claim 8.